(19) Europäisches Patentamt

European Patent Office

Office européen des brevets

(11) **EP 0 810 609 B1**

(12) **EUROPÄISCHE PATENTSCHRIFT**

(45) Veröffentlichungstag und Bekanntmachung des Hinweises auf die Patenterteilung:
**06.03.2002 Patentblatt 2002/10**

(51) Int Cl.[7]: **G11C 11/34**, G11C 11/40

(21) Anmeldenummer: **97107314.3**

(22) Anmeldetag: **02.05.1997**

(54) **Einzelelektron-Speicherzellenanordnung**

Single electron memory cell device

Dispositif de cellule de mémoires à électron unique

(84) Benannte Vertragsstaaten:
**AT DE FR GB IE IT NL**

(30) Priorität: **31.05.1996 DE 19621994**

(43) Veröffentlichungstag der Anmeldung:
**03.12.1997 Patentblatt 1997/49**

(73) Patentinhaber: **Infineon Technologies AG**
**81669 München (DE)**

(72) Erfinder:
• **Risch, Lothar, Dr.**
**85579 Neubiberg (DE)**
• **Rösner, Wolfgang, Dr.**
**81739 München (DE)**

(74) Vertreter:
**Patentanwaltskanzlei WILHELM & BECK**
**Nymphenburger Strasse 139**
**80636 München (DE)**

(56) Entgegenhaltungen:
• **NAKAZATO K ET AL: "SINGLE-ELECTRON MEMORY" ELECTRONICS LETTERS, Bd. 29, Nr. 4, 18. Februar 1993, Seite 384/385 XP000346076**
• **NAKAZATO K ET AL: "SINGLE-ELECTRON MEMORY" JOURNAL OF APPLIED PHYSICS, Bd. 75, Nr. 10, PART 01, 15. Mai 1994, Seiten 5123-5134, XP000456680**
• **KAZUO YANO ET AL: "A ROOM-TEMPERATURE SINGLE-ELECTRON MEMORY DEVICE USING FINE-GRAIN POLYCRYSTALLINE SILICON" PROCEEDINGS OF THE INTERNATIONAL ELECTRON DEVICES MEETING, WASHINGTON, DEC. 5 - 8, 1993,5. Dezember 1993, Seiten 541-544, XP000481675 INSTITUTE OF ELECTRICAL AND ELECTRONICS ENGINEERS**
• **KANUO YANO ET AL: "ROOM-TEMPERATURE SINGLE-ELECTRON MEMORY" IEEE TRANSACTIONS ON ELECTRON DEVICES, Bd. 41, Nr. 9, 1. September 1994, Seiten 1628-1638, XP000466806**

**Beschreibung**

Speicherzellenanordnungen mit wahlfreiem dynamischem Zugriff, DRAM, werden derzeit hauptsächlich in CMOS-Technologie hergestellt. Sie umfassen Speicherzellen mit jeweils einem Auslesetransistor und einem Kondensator. Auf dem Kondensator wird die zu speichernde Information in Form einer Ladungsmenge gespeichert. Üblicherweise beträgt die Signalladung etwa 50 fC, das heißt sie besteht aus 300000 Elektronen. Die Kapazität des Kondensators in heutigen Speicherzellen beträgt 20 bis 30 fF.

Mit zunehmender Packungsdichte zukünftiger Speicheranordnungen nimmt die Fläche pro Speicherzelle ab. Dabei wird es immer schwieriger bis schließlich unmöglich auf der für die Speicherzelle zur Verfügung stehenden Fläche einen Kondensator mit der relativ großen Speicherkapazität von 20 bis 30 fF herzustellen. Auch der Auslesetransistor kann nicht beliebig verkleinert werden.

Im Hinblick auf eine weitere Miniaturisierung sind sogenannte Einzelelektron-Bauelemente vorgeschlagen worden, in denen Schaltvorgänge mit einzelnen Elektronen realisiert werden. Eine Untersuchung über derartige Einzelelektron-Bauelemente ist zum Beispiel aus W. Rösner et al, Microelectronic Engineering, Bd. 27, 1995, Seiten 55 bis 58, bekannt. Einzelelektron-Bauelemente umfassen Tunnelelemente, die über Tunnelkontakte mit benachbarten Anschlüssen verbunden sind. Ladungsübertritte über diese Tunnelkontakte erfolgen sowohl über den quantenmechanischen Tunneleffekt als auch durch einfache thermische Überwindung einer Potentialbarriere, wobei diese Ladungsübertritte hinreichend selten auftreten. Die Tunnelelemente sind zum Beispiel als kleine leitfähige Inseln realisiert, die von einer isolierenden Struktur umgeben sind.

Wird an die beiden Anschlüsse eine Spannung U angelegt, für die die Bedingung für Coulomb-Blockade erfüllt ist, das heißt für deren Betrag $|U| < e/(2C)$ gilt, so kann sich die Ladung des Tunnelelementes aufgrund der Potentialverhältnisse nicht verändern, sofern für die thermische Energie $\frac{kT}{e} << \frac{e}{2C}$ gilt. Dabei ist k, die Stephan-Boltzmann-Konstante, T die Temperatur, e eine Elektronenladung, C die Kapazität des Tunnelelementes.

Bei Anlegen einer höheren Spannung können Elektronen über einen der Tunnelkontakte auf das Tunnelelement fließen. Diese Einzelelektron-Bauelemente werden so betrieben, daß jeweils ein Übertritt einzelner Elektronen erfolgt.

Durch Ansteuerung des Tunnelelementes über eine Gateelektrode, die das Tunnelelement kapazitiv beeinflußt, ohne daß es im Betriebsspannungsbereich zu Tunnelübergängen käme, ist ein Stromfluß über das Tunnelelement möglich. Sofern an der Gateelektrode eine geeignete elektrische Ladung wirksam ist, weist das Einzelelektron-Bauelement eine in etwa lineare, durch den Nullpunkt gehende Stromspannungskennlinie auf. Ein derartiges gategesteuertes Einzelelektron-Bauelement wird in der Literatur als Einzelelektron-Transistor bezeichnet.

In K. Nakazato et al, J. Appl. Phys., Bd. 75, Nr. 10, 1994, Seiten 5123-5134, ist eine Einzelelektron-Speicherzelle vorgeschlagen worden. Diese umfaßt drei sogenannte Multitunnelelemente. Als Multitunnelelement wird eine Reihenschaltung von Tunnelelementen bezeichnet, die jeweils über einen Tunnelkontakt miteinander verbunden sind. Die Multitunnelelemente weisen jeweils eine seitliche Gateelektrode auf, über die ein Strom durch die Multitunnelelemente steuerbar ist. Ein erstes Multitunnelelement und ein zweites Multitunnelelement ist dabei zwischen eine erste Spannungsquelle und Masse in Reihe verschaltet. Die beiden Multitunnelelemente sind über einen Speicherknoten miteinander verbunden. Die seitlichen Gateelektroden der Multitunnelelemente sind mit einer zweiten Spannungsquelle bzw. einer dritten Spannungsquelle verbunden.

Der Speicherknoten ist über eine Kapazität mit einer vierten Spannungsquelle verbunden. Der Speicherknoten ist über eine weitere Kapazität mit einem dritten Multitunnelelement verbunden, das zwischen eine fünfte Spannungsquelle und Masse geschaltet ist. Das dritte Multitunnelelement wird ebenfalls durch eine seitliche Gateelektrode angesteuert, die mit einer sechsten Spannungsquelle verbunden ist.

Das dritte Multitunnelelement wirkt als Elektrometer, mit dem auf dem Speicherknoten befindliche Ladung nachgewiesen wird. Messungen, bei denen die seitliche Gateelektrode des zweiten Multitunnelelementes mit einer hohen negativen Spannung beaufschlagt wurde, haben ergeben, daß in dem ersten Multitunnelelement und im Speicherknoten einzelne Elektronen stabil gespeichert werden können, sofern die an das Multitunnelelement angelegte Spannung die Bedingung für Coulomb-Blockade erfüllt. Abhängig von der an die seitliche Gateelektrode angelegten Spannung können in dem aus Speicherknoten und erstem Multitunnelelement gebildeten Speicherelement eine diskrete Anzahl von Elektronen stabil gespeichert werden. Dieses wird damit erklärt, daß die elektrostatische Energie des Speicherelementes für die jeweils entsprechende Anzahl gespeicherter Elektronen einen metastabilen Zustand einnimmt. Zwischen benachbarten, metastabilen Zuständen weist die elektrostatische Energie einen Potentialwall auf, dessen Scheitel höher als der nächste metastabile Zustand ist. Die Höhe der Potentialwälle hängt von der Anzahl der gespeicherten Elektronen und der Anzahl der Tunnelkontakte im Multitunnelelement ab.

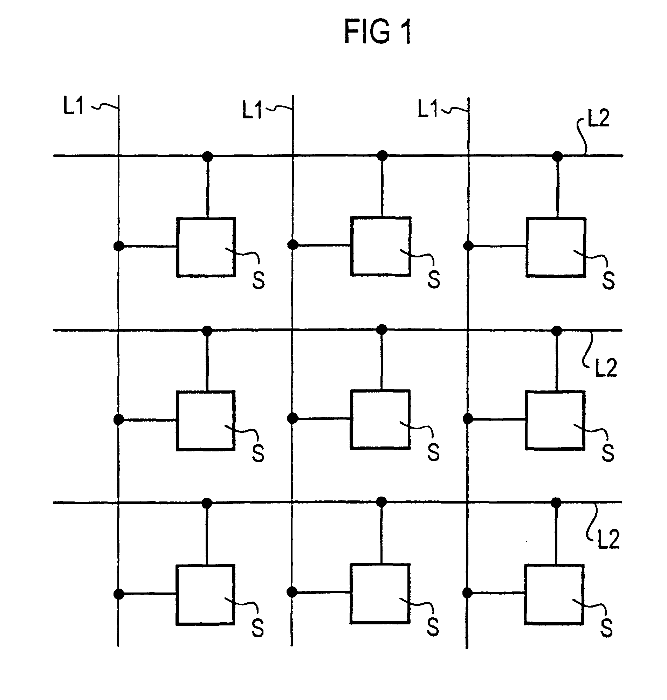

Aus KAZUO YANO ET AL: 'A ROOM-TEMPERATURE SINGLE-ELECTRON MEMORY DEVICE USING FINE-GRAIN POLYCRYSTALLINE SILICON' PROCEEDINGS OF THE INTERNATIONAL ELECTRON DEVICES MEETING, WASHINGTON, DEC. 5 - 8, 1993,5. Dezember 1993, Seiten 541-544, XP000481675 INSTITUTE OF ELECTRICAL AND ELECTRONICS ENGINEERS ist eine Einzelelektron-Speicherzellenanordnung bekannt (cf Fig.1, "conventional"), bei der die Speicherzellen jeweils ein EinzelelektronSpeicherelement (vergl. den linken Schaltungsteil mit einem ersten "MTJ" und "storage node" zwischen "reservoir" und "gate") und einen Einzelelektron-Transistor (vergl. den rechten Schaltungsteil mit einem zweiten "MTJ" zwischen "source" und "drain") umfassen, bei der das Einzelelektron-Speicherelement mindestens ein Tunnelelement umfasst, das über einen ersten Tunnelkontakt mit dem resevoir und über einen zweiten Tunnelkontakt mit einem Speicherknoten (storage node) verbunden ist, der über eine erste Gateelektrode (gate) kapazitiv ansteuerbar ist, und bei der der Einzeielektron-Transistor ein Tunnelelement umfasst, das über einen ersten Tunnelkontakt mit der "source" und über einen zweiten Tunnelkontakt mit der "drain" verbunden ist und das über eine zweite Gateelektrode, die mit dem Speicherknoten verbunden ist, kapazitiv ansteuerbar ist.

Die Einzelelektron-Speicherzelle ist in Delta-dotiertem GaAs realisiert. Da zum Betrieb der Einzelelektron-Speicherzelle sechs Spannungsquellen erforderlich sind, ist eine Speicherzellenanordnung, die eine Vielzahl derartiger Speicherzellen umfaßt, aufwendig ansteuerbar.

Der Erfindung liegt daher das Problem zugrunde, eine Einzelelektron-Speicherzellenanordnung anzugeben, die mit einem geringeren Aufwand ansteuerbar ist.

Dieses Problem wird erfindungsgemäß gelöst durch eine Einzelelektron-Speicherzellenanordnung, die Speicherzellen mit jeweils einem Einzelelektron-Speicherelement und einem Einzelelektron-Transistor umfassen. Jede der Speicherzellen ist zwischen eine erste Leitung und eine zweite Leitung geschaltet. Die Speicherzellenanordnung umfaßt parallel verlaufende erste Leitungen und parallel verlaufende zweite Leitungen, wobei die ersten Leitungen und die zweiten Leitungen quer zueinander verlaufen. Die ersten Leitungen und die zweiten Leitungen sind vergleichbar mit den Wort- und Bitleitungen in derzeitigen DRAM-Anordnungen.

Da in der erfindungsgemäßen Einzelelektron-Speicherzellenanordnung jede Speicherzelle zwischen eine der ersten Leitungen und eine der zweiten Leitungen geschaltet ist, läßt sich jede der Speicherzellen durch Anlegen entsprechender Spannungspegel an die zugehörige erste Leitung und die zugehörige zweite Leitung einfach ansteuern.

Das Einzelelektron-Speicherelement umfaßt mindestens ein Tunnelelement, das über einen ersten Tunnelkontakt mit der ersten Leitung und über einen zweiten Tunnelkontakt mit einem Speicherknoten verbunden ist, der über eine erste Gateelektrode kapazitiv ansteuerbar ist. Über die Tunnelkontakte erfolgen Ladungsübertritte sowohl durch quantenmechanischen Tunneleffekt als auch durch hinreichend seltene thermische Überwindung einer Potentialbarriere. Ist der Tunnelwiderstand $R_T > R_K = h/e^2 \approx 26k\Omega$, wobei $R_K$ der Klitzing-Widerstand, h das Plancksche Wirkungsquantum und e eine Elektronenladung ist, so erfolgt die Mehrzahl der Ladungsübertritte durch Elementarprozesse. Vorzugsweise ist der Tunnelwiderstand größer 100 kΩ, so daß die Elementarprozesse beim Ladungsübertritt überwiegen. Die erste Gateelektrode ist mit der zweiten Leitung verbunden. Der Einzelelektron-Transistor ist über einen ersten Anschluß mit der ersten Leitung und über einen zweiten Anschluß mit der zweiten Leitung verbunden. Über eine zweite Gateelektrode, die mit dem Speicherknoten verbunden ist, ist er kapazitiv ansteuerbar.

Die Kapazitäten des Speicherelementes und des Einzelelektron-Transistors sind so abgestimmt, daß bei Anliegen einer Lesespannung durch den Einzelelektron-Transistor ein von einer im Speicherelement gespeicherten Ladung abhängiger Strom fließt. Die im Speicherelement gespeicherte Ladung wird dabei nicht verändert. Durch Anlegen einer Schreibspannung, die betragsmäßig größer als die Lesespannung ist, ist dagegen die im Speicherelement gespeicherte Ladung veränderbar.

Die Erfindung macht sich die Erkenntnis zunutze, daß ein Einzelelektron-Transistor ein empfindliches Elektrometer für eine an der Gateelektrode des Einzelelektron-Transistors wirksame Ladung ist. Die Lesespannung wird so gewählt, daß die Bedingung für Coulomb-Blockade erfüllt ist. Der über den Einzelelektron-Transistor fließende Strom ist abhängig von der auf dem Speicherknoten befindlichen Ladung, da der Speicherknoten mit der zweiten Gateelektrode des Einzelelektron-Transistors verbunden ist. Gleichzeitig wird eine Veränderung der auf dem Speicherknoten gespeicherten Ladung dadurch verhindert, daß die an der ersten Gateelektrode anliegende Lesespannung zu einer Änderung der auf dem Speicherknoten befindlichen elektrischen Ladung nicht ausreicht. Dabei wird ausgenutzt, daß die Anzahl der Elektronen, die stabil in einem Multitunnelelement gespeichert werden können sowohl von der Anzahl der Tunnelkontakte in dem Multitunnelelement als auch von der Gatespannung, mit der das Multitunnelelement angesteuert wird, abhängt.

Die Kapazitäten des Einzelelektron-Speicherelementes und des Einzelelektron-Transistors werden so aufeinander abgestimmt, daß gleichzeitig bei Anliegen der Lesespannung für den Einzelelektron-Transistor die Bedingung für Coulomb-Blockade erfüllt ist und eine Veränderung des Ladungszustands des Einzelelektron-Speicherelementes nicht möglich ist. Bei der betragsmäßig höheren Schreibspannung wird dagegen eine Veränderung des Ladungszustandes des Speicherknotens bewirkt.

Zur Ansteuerung einer Speicherzelle zum Lesen der Information wird zwischen die zugehörigen erste Leitung und zweite Leitung ein Spannungspegel entsprechend der Lesespannung angelegt. Die übrigen ersten Leitungen und zweiten Leitungen werden mit demselben Potential wie die ausgewählte erste Leitung verbunden, so daß alle Zellen, die nicht zu der ausgewählten zweiten Leitung gehören, spannungsfrei sind. Zum Einschreiben von Informationen in eine Speicherzelle wird zwischen die zugehörige erste Leitung und zweite Leitung ein Spannungspegel entsprechend der Schreibspannung angelegt. Die übrigen ersten Leitungen und zweiten Leitungen werden so beschaltet, daß über die übrigen Speicherzellen ein geringerer Spannungspegel abfällt, bei dem keine Veränderung der gespeicherten Ladung auftritt. Die übrigen Leitungen können zum Beispiel mit einem Spannungspegel entsprechend der Lesespannung oder der Differenz von Schreib- und Lesespannung beaufschlagt werden.

Vorzugsweise werden die Kapazitäten des Speicherelementes und des Einzelelektron-Transistors so abgestimmt, daß der Betrag der Lesespannung halb so groß wie der Betrag der Schreibspannung ist. Beim Einschreiben von Information in eine Speicherzelle können in diesem Fall die übrigen ersten Leitungen und die zweiten Leitungen mit der Lesespannung beaufschlagt werden und es fällt über einen Teil der nicht ausgewählten Speicherzellen immer dieselbe Spannung ab. Die übrigen nicht ausgewählten Speicherzellen sind spannungsfrei.

Vorzugsweise umfaßt das Speicherelement mehrere Tunnelelemente, die untereinander jeweils über Tunnelkontakte als Reihe miteinander verbunden sind. Für die Eigenschaften dieser Tunnelkontakte gilt das in bezug auf den ersten Tunnelkontakt und den zweiten Tunnelkontakt Gesagte. Das erste Tunnelelement ist dabei über den ersten Tunnelkontakt mit der ersten Leitung und das in der Reihe letzte Tunnelelement über den zweiten Tunnelkontakt mit dem Speicherknoten verbunden. Das Vorsehen mehrerer Tunnelkontakte im Speicherelement führt dazu, daß die Anzahl der stabilen Ladungszustände in dem Speicherelement für eine feste Spannung an der ersten Gateelektrode zunimmt.

Als Tunnelelemente kommen alle Strukturen in Betracht, die einen elektrisch leitfähigen Bereich umfassen und die über eine Isolationsstruktur gegenüber benachbarten elektrisch leitfähigen Bereichen isoliert sind. Über die Isolationsstruktur sind die elektrisch leitfähigen Bereiche durch Tunnelkontakte verbunden. Als Tunnelelemente sind insbesondere Strukturen geeignet, die einen leitfähigen Kern und einen den leitfähigen Kern umgebende isolierende Hülle umfassen. Der Durchmesser des Tunnelelements liegt dabei vorzugsweise zwischen 1 und 10 nm. Die Kapazität der Tunnelelemente ist in diesem Größenbereich so klein, daß die Speicherzellenanordnung im Raumtemperaturbereich funktioniert. Insbesondere sind als Tunnelelemente Metallcluster mit organischen Liganden als isolierende Hülle, wie sie aus DE 42 12 220 A1 bekannt sind, oder Fullerene mit eingeschlossenem Metallkern geeignet.

Desweiteren sind als Tunnelelemente lithographisch strukturierte dünne Metallschichten geeignet, wobei die Tunnelkontakte durch Oxidation einer solchen Metallschicht und nachfolgender Abscheidung und Strukturierung einer weiteren Metallschicht entstehen.

Im Rahmen einer molekularen Elektronik sind als Tunnelelemente auch Abschnitte einzelner Moleküle geeignet, die abhängig von ihrer Vorgeschichte unterschiedliche Ladungen tragen können. Der Ladungsübertritt zwischen solchen umladbaren Molekülabschnitten erfolgt entlang chemischer Bindungen.

Unter der Voraussetzung, daß der Tunnelwiderstand der Tunnelkontakte $R_T >> R_K = h/e^2 \approx 26\,k\Omega$, wobei $R_K$ der Klitzing-Widerstand, h das Plancksche Wirkungsquantum und e eine Elektronenladung ist, daß das elektrische Verhalten der Speicherzelle durch die Tunnelkontakte, die Kapazitäten und die Spannungspegel an der ersten Leitung und der zweiten Leitung ausreichend genau bestimmt ist und Leitungswiderstände und Wechselstromwiderstände vernachlässigbar sind, daß jeweils nur ein Tunnelübergang über einen Tunnelkontakt erfolgt, so daß während des Tunnelübergangs die übrigen Tunnelkontakte als Kapazitäten zu betrachten sind, daß alle Tunnelkontakte gleiche Kapazität aufweisen und daß die Kapazitätsbeiträge der übrigen Speicherzellen der Speicherzellenanordnung vernachlässigbar sind, gilt für stabile Ladungszustände in dem Speicherelement

$$\frac{C_G}{e} \cdot V - \frac{1}{2}(m-\gamma) < I < \frac{C_G}{e} \cdot V + \frac{1}{2}(m-\gamma)$$

mit $m = 1 + n\,\gamma$

$$\gamma = \frac{C_G}{C}$$

wobei

$C_G$ Kapazität der ersten Gateelektrode
C Kapazität eines Tunnelkontaktes im Speicherelement
n Anzahl der Tunnelkontakte im Speicherelement
V Spannung an der 1. Gateelektrode
I Anzahl der im Speicherelement gespeicherten Elektronen
e Elektronenladung

sind.

Für eine Speicherzelle, die bei Anlegen einer Schreibspannung $\pm V_{Schreib}$ die stabilen Zustände + e und - e einnimmt, folgt aus der Bedingung für stabile Ladungszustände

$$\frac{C_G}{e} \cdot V_{Schreib} - \frac{1}{2}(m-\gamma) < 1 < \frac{C_G}{e} \cdot V_{Schreib} + \frac{1}{2}(m-\gamma)$$

Die Bedingung, daß der Ladungszustand null Elektronen bei Anliegen der Schreibspannung $V_{Schreib}$ instabil ist, führt zu

$$0 < \frac{C_G}{e} \cdot V_{Schreib} - \frac{1}{2}(m-\gamma).$$

Bei Anliegen der Lesespannung $V_{Lese}$ soll insbesondere der Ladungszustand +e stabil sein, also

$$\frac{C_G}{e} \cdot V_{Lese} - \frac{1}{2}(m-\gamma) < -1,$$

und weiterhin soll für den Einzelelektron-Transistor die Bedingung für Coulomb-Blockade erfüllt sein:

$$V_{Lese} < \frac{e}{C_{\Sigma t}}$$

$C_{\Sigma t}$ Gesamtkapazität des Transistors.

Die Gesamtkapazität des Einzelelektron-Transistors ergibt sich als Summe der Kapazitäten der Tunnelkontakte, die den Einzelelektron-Transistor bilden und der Kapazität der zweiten Gateelektrode.

Diese Bedingungen sind erfüllt für folgende Spannungen und Kapazitäten:

$$V_{Lese} = 1/2 \cdot V_{Schreib}$$

$$C_G = \frac{4e}{V_{Schreib}}$$

$$C = \frac{n-1}{6} C_G$$

$$C_{\Sigma t} \leq \frac{1}{2} C_G$$

Die Erfindung ist nicht auf diese Kapazitätswerte beschränkt. Durch Wahl einer anderen Lesespannung $V_{Lese}$, durch Ausnutzung des vollen Bereichs der Ungleichungen, durch Vorgabe anderer und / oder mehr stabiler Ladungszustände bei der Lese- beziehungsweise Schreibspannung oder durch andere Annahmen bei der Ableitung des Stabilitätskriteriums, zum Beispiel daß die Tunnelkontakte unterschiedliche Kapazität aufweisen, lassen sich in analoger Weise andere Kriterien für die Kapazitäten bestimmen.

Im folgenden wird die Erfindung anhand der Figuren und eines Ausführungsbeispiels näher erläutert.

Figur 1 zeigt ein schematisches Schaltbild einer Speicherzellenanordnung.

Figur 2 zeigt eine Aufsicht auf eine Speicherzelle.

Figur 3 zeigt das Ersatzschaltbild für die in Figur 2 dargestellte Speicherzelle.

Figur 4 zeigt Kennlinien der Speicherzelle.

Eine Speicherzellenanordnung umfaßt erste Leitungen L1, die im wesentlichen parallel zueinander verlaufen und zweite Leitungen L2, die ebenfalls im wesentlichen parallel zueinander verlaufen. Die ersten Leitungen L1 verlaufen dabei quer zu den zweiten Leitungen L2 (siehe Figur 1).

Die Speicherzellenanordnung umfaßt Speicherzellen S, die jeweils zwischen einem der ersten Leitungen L1 und eine der zweiten Leitungen L2 geschaltet sind. Durch Ansteuerung einer der ersten Leitungen L1 und einer der zweiten Leitungen L2 läßt sich damit jede der Speicherzellen S eindeutig ansteuern.

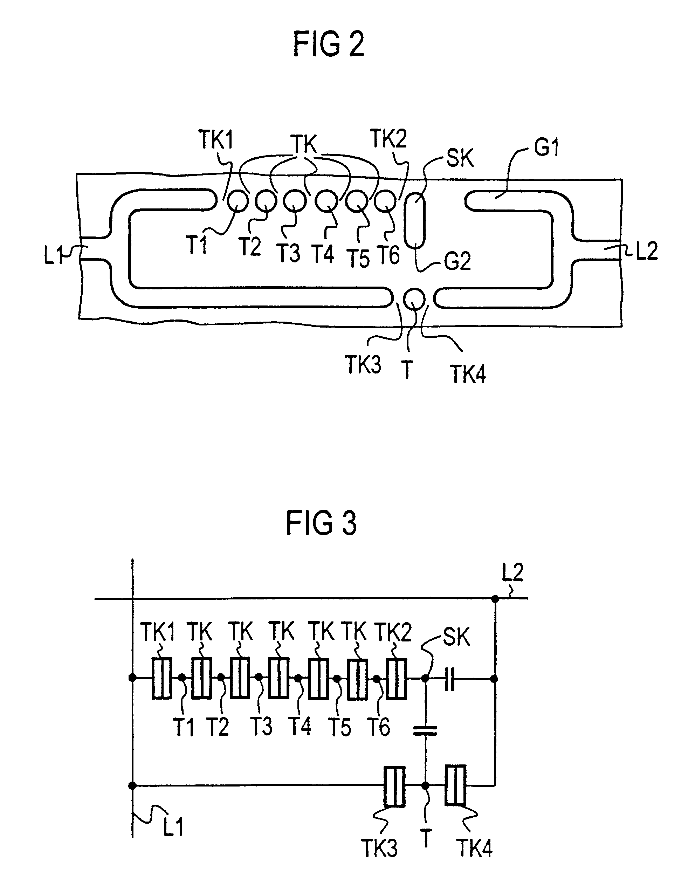

Jede der Speicherzellen umfaßt sechs Tunnelelemente T1, T2, T3, T4, T5, T6, die untereinander über Tunnelkontakte TK miteinander verbunden sind. Das erste der Tunnelelemente T1 ist über einen ersten Tunnelkontakt TK1 mit einem Anschluß einer der ersten Leitungen L1 verbunden. Das in der Reihe letzte der Tunnelelemente T6 ist über einen zweiten Tunnelkontakt TK2 mit einem Speicherknoten SK verbunden. Der Speicherknoten SK ist über eine erste Gateelektrode G1 kapazitiv ansteuerbar. Der Abstand zwischen der ersten Gateelektrode G1 und dem Speicherknoten SK ist so groß, daß bei den in der Speicherzellenanordnung vorgesehenen Betriebsspannungen kein Tunnelübergang zwischen der ersten Gateelektrode G1 und dem Speicherknoten SK erfolgt (siehe Figur 2 und Figur 3). Die erste Gateelektrode G1 ist mit einer der zweiten Leitungen L2 verbunden.

Die erste Gateelektrode G1, der Speicherknoten SK sowie die Tunnelelemente T1, T2, T3, T4, T5, T6 mit den dazwischen befindlichen Tunnelkontakten TK1, TK, TK2 bilden ein Speicherelement.

Ferner umfaßt jede der Speicherzellen ein Transistortunnelelement T, das über einen ersten Transistortunnelkontakt TK3 mit einem Anschluß der ersten Leitung L1 verbunden ist und das über einen zweiten Transistortunnelkontakt TK4 mit einem Anschluß der zweiten Leitung L2 verbunden ist. Das Transistortunnelelement T wird über eine zweite Gateelektrode G2, die mit dem Speicherknoten SK verbunden ist, angesteuert. Der Abstand zwischen der zweiten Gateelektrode G2 und dem Transistortunnelelement T ist so groß, daß die Ansteuerung kapazitiv erfolgt und daß bei den Betriebsspannungen der Speicherzellenanordnung ein Tunnelübergang zwischen der zweiten Gateelektrode G2 und dem Transistortunnelelement T unterbleibt. Das Transistortunnelelement T, der erste Transistortunnelkontakt TK3, der zweite Transistortunnelkontakt TK4 und die zweite Gateelektrode G2 bilden einen Einzelelektron-Transistor.

Die Tunnelelemente T1, T2, T3, T4, T5, T6 werden zum Beispiel als leitfähige Inseln mit zum Beispiel rundem Querschnitt auf einer isolierenden Oberfläche realisiert. Die Tunnelelemente T1, T6 werden zum Beispiel aus Gold, Aluminium oder Titan mit einem Durchmesser von zum Beispiel 3 nm gebildet. Die isolierende Oberfläche, auf der die Speicherzelle angeordnet ist, ist zum Beispiel die Oberfläche einer $SiO_2$-Schicht, die auf einem Siliziumsubstrat angeordnet ist. Die Speicherzellenanordnung kann ferner auf einem Substrat aus Saphir angeordnet werden.

Der Abstand benachbarter Tunnelelemente T1, T2, T3, T4, T5, T6 und damit die Abmessungen der Tunnelkontakte TK1, TK, TK2 beträgt zum Beispiel 2 nm. Der Speicherknoten SK und die zweite Gateelektrode G2, sowie die erste Gateelektrode G1 und die Leitungen L1 und L2 werden zum Beispiel als metallische Gebiete auf der isolierenden Oberfläche realisiert. Sie werden ebenfalls aus Gold, Aluminium oder Titan gebildet. Der Abstand zwischen der ersten Gateelektrode G1 und dem Speicherknoten SK beträgt zum Beispiel 5 nm.

Die Abmessungen des Speicherknotens SK betragen zum Beispiel 3 nm.

Das Transistortunnelelement T ist ebenfalls als leitfähige Insel zum Beispiel aus Gold, Aluminium oder Titan mit zum Beispiel rundem Querschnitt mit einem Durchmesser von 3 nm gebildet. Die Anschlüsse zur ersten Leitung L1 und zur zweiten Leitung L2 sind ebenfalls als metallische Leiterbahnen aus zum Beispiel Gold, Aluminium und Titan realisiert. Der Abstand des Transistortunnelelementes zu den Anschlüssen zur ersten Leitung L1 bzw. zweiten Leitung L2 und damit die Abmessungen der Transistortunnelkontakte TK3, TK4 betragen 2 nm. Der Abstand zwischen der zweiten Gateelektrode G2 und dem Transistortunnelelement T beträgt 5 nm.

Der Flächenbedarf pro Speicherzelle beträgt etwa 500 nm². Eine 1Tbit-Speicherzellenanordnung ist damit auf einer Fläche von 5 cm² realisierbar.

Die Speicherzelle wird zum Beispiel durch Abscheidung einzelner Metallatome auf einer isolierenden Oberfläche mithilfe eines Rastertunnelmikroskops oder eines Atomkraftmikroskops hergestellt.

Alternativ kann eine ganzflächige Metallschicht einer Dicke von zum Beispiel 3 nm durch Lithgraphie, insbesondere unter Verwendung von Elektronenstrahlung oder Synchrotronstrahlung, oder durch Oxidation mit einem Rastersondenmikroskop strukturiert werden.

Die nicht leitenden Zwischenräume zwischen den Tunnelelementen können sowohl durch Oxidation einer ursprünglich metallischen Schicht als auch unter Verwendung lithographischer Verfahren und reaktivem Ionenätzen hergestellt werden.

Beispielsweise beträgt der Tunnelwiderstand der Tunnelkontakte TK1, TK, TK2 jeweils 100 kΩ und die zugehörige Kapazität beträgt jeweils 1 aF. Die Kapazität der ersten Gateelektrode $C_G$ beträgt 1 aF. Die Kapazität der Transistortunnelkontakte TK3, TK4 beträgt jeweils 0,1 aF. Die Kapazität der zweiten Gateelektrode G2 beträgt 0,3 aF. Damit beträgt die Gesamtkapazität des Einzelelektron-Speichertransistors

$$C_{\Sigma t} = 2 \cdot C_t + C_{tg} = 0,5aF.$$

Die Speicherzelle wird mit einer Lesespannung $V_{Lese}$ von 0,32 Volt und einer Schreibspannung von 0,64 Volt betrieben.

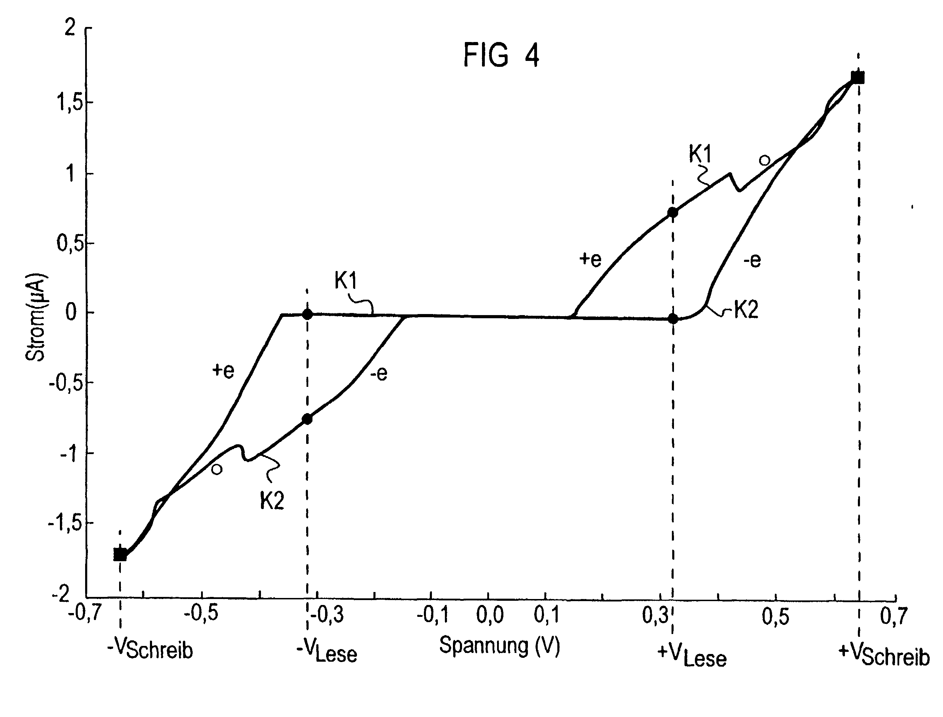

Anhand der in Figur 4 dargestellten Kennlinien der Speicherzelle wird im folgenden der Betrieb der Speicherzelle erläutert. In Figur 4 sind eine erste Kennlinie K1 und eine zweite Kennlinie K2 dargestellt. Die erste Kennlinie K1 gilt für den Fall, daß in dem Speicherelement der Ladungszustand + e gespeichert ist. Die zweite Kennlinie K2 gilt für den Fall, daß in dem Speicherelement der Ladungszustand - e gespeichert ist. Liegt zwischen der ersten Leitung L1 und der zweiten Leitung L2 eine Spannung **+ $V_{Lese}$** an, und ist in dem Speicherelement der Ladungszustand + e gespeichert, so fließt über den Transistor ein Strom von etwa 0,8 μA. Ist dagegen der Ladungszustand - e gespeichert, so fließt bei Anlegen einer Spannung von **+ $V_{Lese}$** kein Strom über den Transistor.

Bei Anlegen einer Spannung von **- $V_{Lese}$** fließt kein Strom über den Transistor, falls der Ladungszustand + e gespeichert ist und ein Strom von etwa - 0,8 μA, falls der Ladungszustand - e gespeichert ist.

Durch Anlegen der Schreibspannung **+ $V_{Schreib}$** steigt, falls der Ladungszustand + e gespeichert ist, der Strom an, es wird der Ladungszustand Null durchlaufen, der instabil ist und es wird bei Erreichen des Pegels **+ $V_{Schreib}$** der Ladungszustand - e in das Speicherelement eingeschrieben. Zum Einschreiben des Ladungszustands + e wird ein Spannungspegel **- $V_{Schreib}$** angelegt, bei dem, falls der Ladungszustand - e gespeichert war, der instabile Zustand Null durchlaufen wird und der Ladungszustand + e in das Speicherelement eingeschrieben wird. Die Lesespannung $V_{Lese}$ ist so gewählt, daß zwar über den Stromfluß deutlich zwischen den Ladungszuständen - e und + e unterschieden werden kann, daß jedoch eine Umladung der stabilen Ladungszustände + e und - e unterbleibt.

**Patentansprüche**

1. Einzelelektron-Speicherzellenanordnung,

   - bei der parallel verlaufende erste Leitungen und parallel verlaufende zweite Leitungen, die quer zu den ersten Leitungen verlaufen, vorgesehen sind,
   - bei der Speicherzellen vorgesehen sind, die jeweils zwischen eine der ersten Leitungen und eine der zweiten Leitungen geschaltet sind,

- bei der die Speicherzellen jeweils ein Einzelelektron-Speicherelement und einen Einzelelektron-Transistor umfassen,
- bei der das Einzelelektron-Speicherelement mindestens ein Tunnelelement umfaßt, das über einen ersten Tunnelkontakt mit der ersten Leitung und über einen zweiten Tunnelkontakt mit einem Speicherknoten verbunden ist, der über eine erste Gateelektrode kapazitiv ansteuerbar ist,
- bei der die erste Gateelektrode mit der zweiten Leitung verbunden ist,
- bei der der Einzelelektron-Transistor ein Tunnelelement umfasst, das über einen ersten Tunnelkontakt mit der ersten Leitung und über einen zweiten Tunnelkontakt mit der zweiten Leitung verbunden ist und das über eine zweite Gateelektrode kapazitiv ansteuerbar ist,
- bei der die zweite Gateelektrode mit dem Speicherknoten verbunden ist,
- bei der die Kapazitäten des Speicherelementes und des Einzelelektron-Transistors so abgestimmt sind, daß bei Anliegen einer Lesespannung, die betragsmäßig geringer als eine Schreibspannung ist, zwischen der ersten Leitung und der zweiten Leitung durch den Einzelelektron-Transistor ein von einer im Speicherelement gespeicherten Ladung abhängiger Strom fließt, ohne die im Speicherelement gespeicherte Ladung zu verändern und daß bei der Anliegen der Schreibspannung zwischen der ersten Leitung und der zweiten Leitung die im Speicherelement gespeicherte Ladung veränderbar ist.

2. Einzelelektron-Speicherzellenanordnung nach Anspruch 1, bei der die Kapazitäten des Speicherelementes und des Einzelelektron-Transistors so abgestimmt sind, daß der Betrag der Lesespannung halb so groß wie der Betrag der Schreibspannung ist.

3. Einzelelektron-Speicherzellenanordnung nach Anspruch 1 oder 2, bei der das Speicherelement mehrere Tunnelelemente umfaßt, die untereinander jeweils über Tunnelkontakte als Reihe verbunden sind, wobei das erste Tunnelelement über den ersten Tunnelkontakt mit der ersten Leitung und das in der Reihe letzte Tunnelelement über den zweiten Tunnelkontakt mit dem Speicherknoten verbunden sind.

4. Einzelelektron-Speicherzellenanordnung nach Anspruch 3, bei der die Tunnelelemente jeweils im wesentlichen dieselbe Kapazität aufweisen.

5. Einzelelektron-Speicherzellenanordnung nach Anspruch 4, bei der für die Kapazitäten in dem Speicherelement und in dem Einzelelektron-Transistor folgende Bedingungen gelten:

$$C_G = \frac{4 \cdot e}{V_{Schreib}}$$

$$V_{Lese} = \frac{1}{2} \cdot V_{Schreib}$$

$$C = \frac{n-1}{6} C_G$$

$$C_{\Sigma t} \leq \frac{1}{2} \cdot C_G$$

mit:

C: Kapazität eines Tunnelkontaktes im Speicherelement
**$C_G$**: Kapazität der ersten Gateelektrode
**$C_{\Sigma t}$**: Gesamtkapazität des Einzelelektron-Transistors
n: Anzahl der Tunnelkontakte im Speicherelement
**$V_{Lese}$**: Lesespannung
**$V_{Schreib}$**: Schreibspannung.

6. Einzelelektron-Speicherzellenanordnung nach einem der Ansprüche 1 bis 5,

- bei der die Tunnelelemente jeweils einen leitfähigen Kern und eine den leitfähigen Kern umgebende isolierende Hülle umfassen,
- bei der der leitfähige Kern und die isolierende Hülle gemeinsam einen Durchmesser zwischen 0,1 nm und 10 nm aufweisen.

7. Einzelelektron-Speicherzellenanordnung nach einem der Ansprüche 1 bis 5,
bei der die Tunnelelemente jeweils Teilbereiche einer ursprünglich ganzflächigen metallischen Schicht sowie nicht leitende Zwischenräume umfassen.

**Claims**

1. Single-electron memory cell arrangement,

- in which parallel first lines and parallel second lines, transverse to the first lines, are provided,
- in which memory cells are provided which are each connected between one of the first lines and one of the second lines,
- in which the memory cells each comprise a single-electron memory element and a single-electron transistor,

- in which the single-electron memory element comprises at least one tunnel element which is connected via a first tunnel contact to the first line, and via a second tunnel contact to a memory node which can be driven capacitively via a first gate electrode,
- in which the first gate electrode is connected to the second line,
- in which the single-electron transistor comprises a tunnel element, which is connected via a first tunnel contact to the first line, and via a second tunnel contact to the second line, and which can be driven capacitively via a second gate electrode,
- in which the second gate electrode is connected to the memory node,
- in which the capacitances of the memory element and of the single-electron transistor are tailored in such a way that, on application of a read voltage whose magnitude is less than a write voltage between the first line and the second line by the single-electron transistor, a current dependent on a charge stored in the memory element flows without changing the charge stored in the memory element, and that, on application of the write voltage between the first line and the second line, the charge stored in the memory element can be changed.

2. Single-electron memory cell arrangement according to Claim 1, in which the capacitances of the memory element and of the single-electron transistor are tailored in such a way that the magnitude of the read voltage is half as much as the magnitude of the write voltage.

3. Single-electron memory cell arrangement according to Claim 1 or 2, in which the memory element comprises a plurality of tunnel elements which are respectively connected to one another as a series via tunnel contacts, the first tunnel element being connected via the first tunnel contact to the first line, and the last tunnel element in the series being connected via the second tunnel contact to the memory node.

4. Single-electron memory cell arrangement according to Claim 3, in which the tunnel elements each have substantially the same capacitance.

5. Single-electron memory cell arrangement according to Claim 4, in which the following conditions are satisfied for the capacitances in the memory element and in the single-electron transistor:

$$C_G = \frac{4 \cdot e}{V_{write}}$$

$$V_{read} = \frac{1}{2} \cdot V_{write}$$

$$C = \frac{n\text{-}1}{6} C_G$$

$$C_{\Sigma_t} \leq \frac{1}{2} \cdot C_G$$

with:

C: Capacitance of a tunnel contact in the memory element
$C_G$: Capacitance of the first gate electrode
$C_{\Sigma t}$: Total capacitance of the single-electron transistor
n: Number of tunnel contacts in the memory element
$V_{read}$: Read voltage
$V_{write}$: Write voltage

6. Single-electron memory cell arrangement according to one of Claims 1 to 5,

- in which the tunnel elements each comprise a conductive core and an insulating shell which surrounds the conductive core,
- in which the conductive core and the insulating shell together have a diameter of between 0.1 nm and 10 nm.

7. Single-electron memory cell arrangement according to one of Claims 1 to 5, in which the tunnel elements each comprise subregions of an originally surface-wide metallic layer and non-conducting gaps.

**Revendications**

1. Agencement de cellule de mémoire à électrons célibataires,

- dans lequel il est prévu des premiers conducteurs qui s'étendent parallèlement et des deuxièmes conducteurs qui s'étendent parallèlement et transversalement aux premiers conducteurs,
- dans lequel il est prévu des cellules de mémoire qui sont montées respectivement entre l'un des premiers conducteurs et l'un des deuxièmes conducteurs,
- dans lequel les cellules de mémoire comprennent respectivement un élément de mémoire à électrons célibataires et un transistor à électrons célibataires,
- dans lequel l'élément de mémoire à électrons célibataires comprend au moins un élément de tunnel qui est relié par un premier contact tunnel au premier conducteur et par un deuxième contact tunnel à un noeud de mémoire qui peut être commandé de manière capacitive par une première électrode de grille,

- dans lequel la première électrode de grille est reliée au deuxième conducteur,
- dans lequel le transistor à électrons célibataires, comprend un élément de tunnel qui est relié par un premier contact tunnel au premier conducteur et par un deuxième contact tunnel au deuxième conducteur, et qui peut être commandé de manière capacitive par une deuxième électrode de grille,
- dans lequel la deuxième électrode de grille est reliée au noeud de mémoire,
- dans lequel les capacités de l'élément de mémoire et du transistor à électrons célibataires sont accordées de façon que lorsque l'on applique une tension de lecture qui est plus petite en valeur absolue qu'une tension d'écriture entre le premier conducteur et le deuxième conducteur, il passe dans le transistor à électrons célibataires un courant électrique dépendant d'une charge emmagasinée dans l'élément de mémoire, sans modifier la charge emmagasinée dans l'élément de mémoire et en ce que lorsque l'on applique la tension d'écriture entre le premier conducteur et le deuxième conducteur, la charge emmagasinée dans l'élément de mémoire peut être modifiée.

2. Agencement de cellules de mémoire à électrons célibataires suivant la revendication 1, dans lequel les capacités de l'élément de mémoire et du transistor à électrons célibataires sont accordées, de façon que la valeur absolue de la tension de lecture soit égale à la moitié de la valeur absolue de la tension d'écriture.

3. Agencement suivant la revendication 1 ou 2, dans lequel l'élément de mémoire comprend plusieurs éléments de tunnel qui sont reliés entre eux respectivement par des contacts tunnel sous la forme d'une série, le premier élément de tunnel étant relié par le premier contact de tunnel au premier conducteur et l'élément de tunnel le dernier dans la série étant relié par le deuxième contact de tunnel au noeud de mémoire.

4. Agencement suivant la revendication 3, dans lequel les éléments de tunnel ont respectivement sensiblement la même capacité.

5. Agencement suivant la revendication 4, dans lequel on a, pour les capacités dans l'élément de mémoire et dans le transistor à électrons célibataires les conditions suivantes :

$$CG = \frac{4 \cdot e}{V_{schreib}}$$

$$V_{Lese} = 1/2 \cdot V_{Schreib}$$

$$C = \frac{n-1}{6} C_G$$

$$C_{\Sigma t} \leq 1/2 \cdot C_G$$

avec :

C : capacité d'un contact de tunnel dans l'élément de mémoire
CG : capacité de la première électrode de grille
$C_{\Sigma t}$ : capacité d'ensemble du transistor à électrons célibataires
n : nombre des contacts de tunnel de l'élément de mémoire
$V_{Lese}$: tension de lecture
$V_{Schreib}$: tension d'écriture.

6. Agencement suivant l'une des revendications 1 à 5,

- dans lequel les éléments de tunnel comprennent respectivement une âme conductrice et une gaine isolante entourant l'âme conductrice,
- dans lequel l'âme conductrice et la gaine isolante ont en commun un diamètre compris entre 0,1 nm et 10 n.

7. Agencement suivant l'une des revendications 1 à 5, dans lequel les éléments de tunnel comprennent respectivement une partie d'une couche métallique initialement sur toute la surface, ainsi que des intervalles non conducteurs.

# FIG 1

## FIG 2

## FIG 3

FIG 4